# FASCICULE DE BREVET EUROPEEN

(11) **EP 0 902 526 B1**
(45) Date de publication et mention de la délivrance du brevet: **05.06.2002**
(21) Numéro de dépôt: 98410099.0
(22) Date de dépôt: 09.09.1998
(51) Int. Cl.: H02M 3/07

(54) **Circuit générateur de tension du type pompe de charge, avec circuit de commande auto-oscillant**
Ladungspumpen-Spannungsgenerator mit selbstschwingender Steuerschaltung
Voltage generator of the charge pump type with self-oscillating control circuit

(30) Priorité: 12.09.1997 FR 9711609
(43) Date de publication de la demande: 17.03.1999
(73) Titulaire: STMicroelectronics S.A., 92120 Montrouge (FR)
(72) Inventeur: Bienvenu, Philippe, 13190 Allauch (FR); Pavlin, Antoine, 13540 Puyricard (FR)
(74) Mandataire: de Beaumont, Michel

(56) Documents cités:
- EP-A- 0 445 083
- FR-A- 2 692 415

## Description

L'invention concerne le domaine des circuits générateurs de tension du type pompe de charge. Elle trouve une application dans le domaine des circuits alimentés par une tension et dans lesquels il est nécessaire de produire une tension supérieure à leur tension d'alimentation.

Les circuits du type pompe de charge sont utilisés, typiquement, pour alimenter des circuits de type capacitif, tels que des grilles de transistors. Un exemple d'application de ces circuits est la fourniture de potentiels de commande de transistors de puissance utilisés comme interrupteurs. Un autre exemple d'application est la fourniture de potentiels de programmation à des transistors à grille flottante, dans les mémoires électriquement programmables.

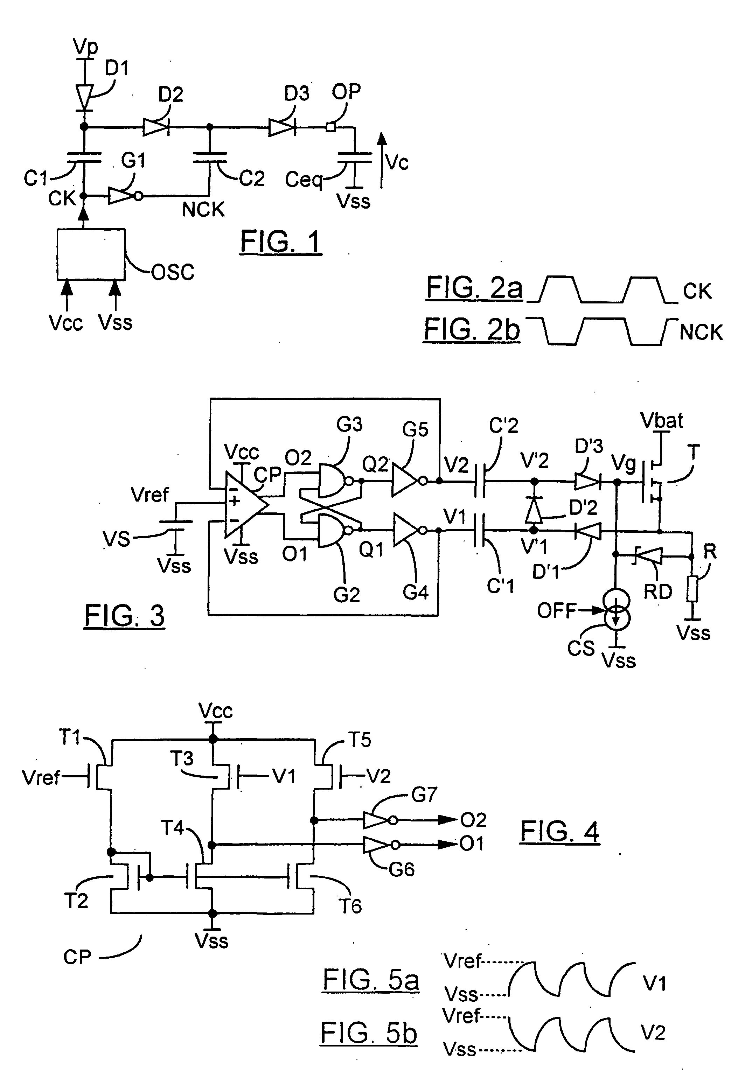

La figure 1 illustre un exemple de circuit générateur du type pompe de charge, selon l'état de la technique. Il alimente, sur une sortie OP, une charge capacitive représentée par un condensateur Ceq. Un pôle du condensateur Ceq est relié à la sortie OP et son autre pôle reçoit un potentiel de référence Vss. On note Vc la tension aux bornes du condensateur.

Un oscillateur OSC, alimenté par le potentiel de référence Vss et par un potentiel d'alimentation Vcc, fournit un signal d'horloge CK, illustré sur la figure 2a. Le signal CK est un signal logique dont le potentiel oscille entre Vcc, à l'état haut, et Vss, à l'état bas. Le signal CK est fourni au premier pôle d'un condensateur C1, et à l'entrée d'un inverseur logique G1. Le condensateur C1 reçoit un potentiel de précharge Vp sur son deuxième pôle, par le biais d'une diode D1. Le potentiel Vp pourra être, par exemple, égal au potentiel Vcc. L'anode de la diode D1 reçoit le potentiel Vp et sa cathode est reliée au deuxième pôle du condensateur C1.

L'inverseur G1 produit un signal logique NCK, illustré sur la figure 2b, par inversion du signal CK. Le signal NCK est fourni au premier pôle d'un condensateur C2. Le deuxième pôle du condensateur C2 est relié, d'une part, à la cathode d'une diode D2 et à l'anode d'une diode D3. L'anode de la diode D2 et la cathode de la diode D3 sont reliées, respectivement, au deuxième pôle du condensateur C1 et à la sortie OP.

On supposera que les diodes D1, D2 et D3 induisent une chute de tension identique Vd lorsqu'elles sont passantes en direct, et que l'on a Vcc > Vd et Vp > Vd. Supposons que le signal CK soit à l'état bas. Le condensateur C1 reçoit le potentiel Vss sur son premier pôle et un potentiel Vp - Vd sur son deuxième pôle. Lorsque le signal CK passe à l'état haut, le potentiel du deuxième pôle du condensateur C1 passe à la valeur (Vp - Vd) + Vcc. On procède alors à un transfert de charges vers le deuxième pôle du condensateur C2, au travers de la diode D2. La diode D1 est alors bloquée et empêche la décharge du condensateur C1 vers le noeud fournissant le potentiel Vp. Le potentiel du deuxième pôle de ce condensateur C2 passe à la valeur Vp+ Vcc - 2 * Vd. Le potentiel du premier pôle du condensateur C2 est alors égal à Vss. Lorsque le signal CK repasse à l'état bas, on bloque la diode D2 et on augmente le potentiel du deuxième pôle du condensateur C2. Ce potentiel passé alors à (Vp + Vcc - 2 * Vd) + Vcc. Par transfert de charges au travers de la diode D3, on va progressivement porter la tension Vc à la valeur (Vp + 2 * Vcc) - 3 * Vd (en considérant que Vss = 0 volt). En utilisant n étages, deux étages successifs recevant respectivement les signaux CK et NCK, on peut ainsi porter le potentiel produit par le circuit générateur de tension à (Vp - Vd) + n * (Vcc - Vd). Le document EP0445083 décrit un circuit similaire, avec un circuit de commande oscillant par le fait de recevoir rétroactivement les potentiels de commande sur ses entrées.

Une caractéristique importante des circuits du type pompe de charge est le délai nécessaire pour que le potentiel produit en sortie atteigne la valeur souhaitée. On cherche généralement à obtenir des délais (encore appelés temps de montée) très courts. En pratique, on peut montrer que le temps de montée est inversement proportionnel à la valeur des condensateurs utilisés. L'utilisation de condensateurs de fortes valeurs permet en effet de transférer, lors de chaque cycle, un nombre de charges plus important vers la sortie, ce qui permet de diminuer le temps de montée. Par contre, l'augmentation des valeurs de condensateur peut poser un problème de réalisation et/ou d'encombrement, dans les circuits intégrés.

Le document FR 26 92 415 décrit un circuit qui permet, à temps de montée égal, de diminuer la valeur des condensateurs.

Pour ce faire, il est proposé de produire les signaux de commande par le biais d'un circuit de commande incorporant un ocillateur autonome et d'éliminer des phases temporelles lors desquelles les potentiels des signaux de commande sont stables, ces phases temporelles correspondant à la fin de phases de charge et de décharge des condensateurs du circuit générateur de tension.

Un but de l'invention est de proposer un circuit amélioré qui regroupe les avantages des circuits connus.

Ainsi l'invention propose un circuit générateur de potentiel du type pompe de charge, comme divulgué par la revendication 1.

Selon un mode de réalisation, le circuit de commande comprend un comparateur pour comparer les potentiels de commande à un potentiel de référence de sorte à modifier les valeurs des potentiels de commande en fonction du résultat de la comparaison.

Selon un mode de réalisation, le potentiel de référence correspond à la première valeur des potentiels de commande.

Selon un mode de réalisation, le circuit de commande comprend une bascule RS en sortie du comparateur, pour garantir un non - recouvrement des potentiels de commande.

Selon un mode de réalisation, le comparateur reçoit les potentiels de commande sur des entrées inverseuses et la bascule est de type NON_ET.

Selon un mode de réalisation, les potentiels de commande sont produits par des circuits tampons pilotés par des sorties de la bascule.

Selon un mode de réalisation, les potentiels de commande sont produits par des circuits tampons pilotés par des sorties du comparateur.

Selon un mode de réalisation, les circuits tampons sont des inverseurs.

D'autres avantages et particularités apparaîtront à la lecture de la description qui suit d'un exemple de réalisation de l'invention, à lire conjointement aux dessins annexés dans lesquels :
- la figure 1 illustre un circuit du type pompe de charge selon l'état de la technique,
- les figures 2a et 2b illustrent des signaux de commande utilisés dans le circuit de la figure 1,
- la figure 3 représente un circuit mettant en oeuvre l'invention,
- la figure 4 représente un comparateur à trois entrées utilisé dans le circuit de la figure 3 et
- les figures 5a et 5b illustrent des potentiels de commande du circuit de la figure 3.

La figure 3 illustre un circuit mettant en oeuvre l'invention. A titre d'exemple, on considérera la commande d'un transistor de puissance T, de type VDMOS à canal N, utilisé comme interrupteur. Le transistor T est utilisé pour relier ou isoler une charge d'une source d'alimentation fournissant un potentiel Vbat, qui pourra par exemple provenir d'une batterie. La charge, représentée par une résistance R, pourra par exemple être un moteur électrique. Le drain du transistor T reçoit le potentiel Vbat. Sa source est reliée à un premier pôle de la résistance R, celle-ci recevant un potentiel bas de référence Vss, inférieur à Vbat, sur son deuxième pôle. On considérera que Vss = 0 volt.

La grille de commande du transistor T reçoit un potentiel de commande Vg qui contrôle l'état, passant ou bloqué, de ce transistor. Pour rendre passant le transistor T, on fournit un potentiel Vg supérieur à Vtr, avec Vtr la tension de seuil du transistor T. Pour bloquer ce transistor, on fournit un potentiel Vg inférieur à Vtr, par exemple Vss. Dans l'exemple illustré sur la figure 3, la grille de commande du transistor T peut être représentée par la capacité équivalente grille - source de ce transistor.

Le circuit illustré sur la figure 3 comprend un circuit générateur de tension du type pompe de charge, ce circuit générateur de tension fournissant le potentiel Vg.

De même que pour l'exemple illustré sur la figure 1, on considérera un circuit à deux étages, c'est-à-dire comprenant deux condensateurs pour fournir le potentiel Vg et des moyens permettant d'isoler ou de relier les condensateurs entre eux.

Un premier condensateur C'1 a un premier pôle relié à la source du transistor T, par le biais d'une diode D'1. Le deuxième pôle du condensateur C'1 reçoit un premier potentiel de commande V1. L'anode et la cathode de la diode D'1 sont reliées, respectivement, à la source du transistor T et au premier pôle du condensateur C'1. On note V'1 le potentiel présent sur le premier pôle du condensateur C'1.

Un deuxième condensateur C'2 a un premier pôle relié au premier pôle du condensateur C'1, par le biais d'une diode D'2. Le deuxième pôle du condensateur C'1 reçoit un deuxième potentiel de commande V2. L'anode et la cathode de la diode D'2 sont reliées, respectivement, au premier pôle du condensateur C'1 et au premier pôle du condensateur C'2. Le premier pôle du condensateur C'2 est également relié à l'anode d'une diode D'3. La cathode de cette diode D'3 est reliée à la grille du transistor T et fournit le potentiel Vg. On note V'2 le potentiel présent sur le premier pôle du condensateur C'2.

Pour produire les potentiels de commande V1 et V2, on utilise un circuit de commande auto - oscillant comprenant un comparateur CP, une bascule de type RS et des circuits tampons. On supposera que ces circuits sont alimentés par un potentiel d'alimentation haut Vcc et par le potentiel de référence Vss.

Les potentiels de commande V1 et V2 pilotent le transfert de charges dans les étages du circuit générateur de tension. Comme on le verra, les potentiels de commande oscillent entre une première et une deuxième valeurs. Lorsque ces potentiels passent de la première valeur à la deuxième valeur, ils commandent une phase de charge des condensateurs. Lorsqu'ils passent de la deuxième valeur à la première valeur, ils commandent une phase de décharge des condensateurs. Le circuit de commande reçoit rétroactivement les potentiels de commande, de sorte que les potentiels de commande sont modifiés dès qu'ils atteignent la première ou la deuxième valeurs.

Le comparateur CP comprend trois entrées. Une entrée non - inverseuse "+" reçoit un potentiel de référence Vref, inférieur à Vcc, fourni par une source de tension VS. Cette source de tension pourra être par exemple un circuit de type bandgap, qui permet de fournir un potentiel de référence relativement précis et stable en température. Une première et une deuxième entrées inverseuses "-" reçoivent, respectivement, le potentiel V1 et le potentiel V2. Comme on le verra ci-dessous, le comparateur est utilisé pour comparer les potentiels de commande au potentiel de référence Vref et pour modifier les valeurs de ces potentiels de commande en fonction du résultat de la comparaison.

Le comparateur CP fournit deux potentiels de sortie O1 et O2. Les valeurs de ces potentiels de sortie sont représentatifs de la comparaison des valeurs des potentiels V1 et V2 à la valeur de Vref. Si on a V1 > Vref, alors O1 = Vss, ce potentiel étant représentatif d'un état logique bas. Si on a V1 < Vref, alors O1 = Vcc, ce potentiel étant représentatif d'un état logique haut. De même, si on a V2 > Vref, alors O2 = Vss, et si on a V2 < Vref, alors O2 = Vcc.

La figure 4 illustre un exemple de réalisation du comparateur CP. Il comprend trois branches, chaque branche étant formée de deux transistors de type MOS à canal N.

Une première branche comprend un premier et un deuxième transistors T1 et T2. Le transistor T1 reçoit, respectivement, les potentiels Vcc et Vref sur son drain et sur sa grille de commande. Sa source est reliée au drain du transistor T2. Le transistor T2 est montée en source de courant de référence et sa grille de commande est reliée à son drain. La source du transistor T2 reçoit le potentiel Vss.

Une deuxième branche comprend un premier et un deuxième transistors T3 et T4. Le transistor T4 reçoit, respectivement, les potentiels Vcc et V1 sur son drain et sur sa grille de commande. Sa source est reliée au drain du transistor T4. La grille de commande du transistor T4 est reliée à la grille de commande du transistor T2 et ces transistors forment un miroir de courant. La source du transistor T4 reçoit le potentiel Vss. Un inverseur G6, comprenant une entrée reliée au drain du transistor T4 et une sortie, fournit le potentiel O1 sur sa sortie. On supposera que cet inverseur est alimenté par les potentiels Vcc et Vss.

Une troisième branche comprend un premier et un deuxième transistors T5 et T6. Le transistor T5 reçoit, respectivement, les potentiels Vcc et V2 sur son drain et sur sa grille de commande. Sa source est reliée au drain du transistor T6. La grille de commande du transistor T6 est reliée à la grille de commande du transistor T2 et ces transistors forment un miroir de courant. La source du transistor T6 reçoit le potentiel Vss. Un inverseur G7, comprenant une entrée reliée au drain du transistor T6 et une sortie, fournit le potentiel O2 sur sa sortie. On supposera que cet inverseur est alimenté par les potentiels Vcc et Vss.

Si, par exemple, le potentiel V1 est supérieur au potentiel Vref, le transistor T3 a tendance a devenir plus passant que le transistor T1. Le courant dans le transistor T4 étant imposé par le transistor T2, le potentiel sur le drain du transistor T4 va augmenter pour atteindre une valeur proche de Vcc. De ce fait, le potentiel O1 va diminuer pour atteindre une valeur proche de Vss.

Si, au contraire, le potentiel V1 est inférieur au potentiel Vref, alors le transistor T3 est moins passant que le transistor T1. Le potentiel du drain du transistor T4 aura alors tendance à diminuer pour atteindre une valeur proche de Vss, et le potentiel O1 aura tendance à augmenter pour atteindre une valeur proche de Vcc.

Il en est de même pour les potentiels V2 et O2.

On pourra bien entendu utiliser deux comparateurs distincts pour fournir les potentiels O1 et O2. L'exemple illustré sur la figure 4 présente l'avantage de minimiser la surface occupée par le circuit générateur de tension.

La bascule RS est de type NON_ET. Elle est donc sensible aux fronts descendants reçus sur ses entrées. Cette bascule est formée de deux portes logiques G2 et G3, de type NON_ET, à deux entrées et une sortie. La porte G2 reçoit le potentiel O1 sur une première entrée. Elle produit un potentiel Q1 sur sa sortie. La porte G3 reçoit le potentiel O2 sur une première entrée et le potentiel Q1 sur une deuxième entrée. Elle produit un potentiel Q2 sur sa sortie. Enfin, la porte G2 reçoit le potentiel Q2 sur une deuxième entrée.

Dans l'exemple illustré, les circuits tampons sont formés d'inverseurs G4 et G5 à une entrée et une sortie. Ces inverseurs reçoivent, respectivement, les potentiels Q1 et Q2. Ils fournissent sur leurs sorties, respectivement, les potentiels de commande V1 et V2. On choisira des circuits tampons permettant de fournir des courants importants aux deuxième pôles des condensateurs, de sorte à minimiser les temps de montée et de descente des potentiels V1 et V2.

On pourra, éventuellement, relier directement les inverseurs G4 et G5 aux sorties du comparateur CP. L'utilisation de la bascule RS permet de garantir un non recouvrement des potentiels de commande. La valeur maximale de l'un ou l'autre des potentiels de commande correspond, d'un point de vue temporel, à la valeur minimale de l'autre potentiel. On garantit alors une excursion maximale de la différence. de potentiel aux bornes des condensateurs. Cette bascule RS permet également. d'éviter des problèmes de blocage des oscillations des potentiels de commande, à basse tension d'alimentation.

Nous allons décrire le fonctionnement du circuit générateur de tension. On note Vtr la chute de tension dans le canal du transistor T à l'état passant et Vd les chutes de tension, supposées identiques, dans les diodes D'1, D'2 et D'3 lorsqu'elles sont polarisées en direct. On suppose par ailleurs que l'on a Vcc > Vref > Vd. Les figures 5a et 5b illustrent les potentiels de commande V1 et V2.

On suppose que le transistor T est initialement bloqué. Il faut augmenter la valeur du potentiel Vg pour que ce transistor devienne passant. Pour ce faire, on va utiliser le potentiel Vss comme potentiel de précharge du condensateur C'1, en supposant que le potentiel V'1 est sensiblement égal au potentiel Vss.

On suppose, par ailleurs, que le potentiel de commande V1 est légèrement inférieur à Vref et décroissant et que le potentiel V2 est inférieur à Vref et croissant. On a donc Q2 = Vss, Q1 = Vcc, O1 = Vcc et O2 = Vcc.

Le potentiel V1 étant décroissant, on va créer une différence de potentiel négative entre les pôles du condensateur C'1. La diode D'1 va devenir passante et on charge le condensateur C'1 au travers de la diode D'1 et de la résistance R.

Lorsque V2 atteint la valeur Vref, le potentiel O2 passe de Vcc à Vss. Par conséquent, le potentiel Q2 monte pour atteindre Vcc. Lorsque le seuil de basculement de l'inverseur G5 est atteint, le potentiel de commande V2 est modifié et passe à Vss. Cette modification du potentiel V2 entraîne une montée à Vcc du signal O2, dès lors que le potentiel V2 devient inférieur à Vref. Parallèlement à la modification du potentiel V2 et comme on a O1 = Vcc, la montée du potentiel Q2 induit une modification du potentiel Q1 qui chute pour atteindre Vss. De ce fait, le potentiel de commande V1 augmente pour atteindre Vref. On va donc augmenter le potentiel du deuxième pôle du condensateur C'1 d'une valeur maximale Vref - Vss = Vref. De ce fait, le potentiel V'1 augmente pour atteindre Vref.

Dès lors que l'augmentation du potentiel V'1 est supérieur à Vd, la diode D'2 est polarisée en direct et l'on transfère des charges du premier condensateur C'1 vers le deuxième condensateur C'2. La diode D'1 est alors bloquée.

Lorsque le potentiel V1 atteint la valeur Vref, le potentiel O1 chute pour atteindre Vss. On assiste alors à une modification du potentiel Q1, qui monte pour atteindre Vcc. Le potentiel V1 va alors diminuer pour tendre vers Vss. La diode D'2 va alors se bloquer.

La modification du potentiel Q1 entraîne parallèlement une modification du potentiel Q2, qui va chuter pour atteindre Vss. On assiste alors à une augmentation du potentiel de commande V2 qui va atteindre Vref. Le potentiel V'2 va donc augmenter pour atteindre une valeur maximale 2 * Vref - Vd. Dès lors que la différence de potentiel devient supérieure à Vd aux bornes de la diode D'3, cette diode devient passante et l'on transfère des charges vers la grille de commande du transistor T. La capacité équivalente grille - source du transistor T va alors se charger. Il suffit que l'on ait 2 * Vref- Vd > Vtr pour que le transistor T devienne passant.

Lorsque le potentiel V2 a atteint sa valeur maximale Vref, on va procéder à nouveau à un transfert de charges du premier condensateur vers le deuxième condensateur, et ainsi de suite.

Dès lors que le transistor T devient passant, le potentiel V'1 va varier entre Vbat - (Vtr + Vd) et (Vbat + Vref) - (Vtr + Vd). Le potentiel V'2, quant à lui, va varier entre (Vbat + Vref) - (Vtr + 2 * Vd) et (Vbat + 2 * Vref) - (Vtr + 2 * Vd). Enfin, le potentiel Vg va atteindre la valeur (Vbat + 2 * Vref) - (Vtr + 3 * Vd).

Le circuit générateur de tension selon l'invention permet, à valeur de condensateur égal, d'obtenir un temps de montée plus court. En effet, on ne fournit pas des signaux de commandes du type signal d'horloge, ces derniers comprenant des phases successives lors desquelles les potentiels sont stabilisés à des valeurs figées. Or, le transfert de charges entre les condensateurs s'effectue en réalité lors des modifications des potentiels de commande. La stabilisation de ces potentiels correspond donc à la fin des phases de transfert de charges.

Dans l'invention, dès qu'une phase de transfert de charges est terminée, on met en route la phase suivante. Les phases de charge et de décharge n'étant pas interrompues, on maximise le nombre de transferts de charges effectués dans un délai donné. On peut donc, pour un temps de montée égal, utiliser des condensateurs de capacité inférieure et moins encombrants.

On choisira de préférence un potentiel Vref proche de Vcc. En effet, le nombre de charges transférées étant proportionnelle à la différence de potentiel aux bornes des condensateurs, le nombre de charges transférées lors d'un transfert sera d'autant plus important que cette différence de potentiel sera importante. Par ailleurs, la valeur du potentiel Vg produit sera d'autant plus élevée que la valeur du potentiel Vref sera élevée.

Le circuit générateur de tension comprend des éléments pour bloquer le transistor T et pour réguler la valeur du potentiel Vg.

Pour bloquer le transistor T, on utilise une source de courant CS commandée logiquement. Cette source permet de décharger la grille du transistor T et de ramener la valeur de ce potentiel à une valeur proche de la valeur du potentiel Vss. Cette source de courant reçoit un signal logique de commande OFF et est agencée de sorte que la grille du transistor T se décharge lorsqu'il est dans un premier état, et que cette source soit bloquée lorsqu'il est dans un second état.

Une diode zener RD est utilisée pour réguler le potentiel Vg. L'anode et la cathode de cette diode sont reliées respectivement à la grille et à la source du transistor T. Cette diode permet de limiter la valeur du potentiel Vg à la valeur absolue de la tension d'avalanche de cette diode.

On pourra modifier le type de portes logiques utilisées, tout en gardant une fonctionnalité comparable. On pourra aussi, par exemple, remplacer les diodes par des transistors montés en diodes.

## Revendications

1. Circuit générateur de potentiel du type pompe de charge, ledit circuit comprenant au moins deux étages formés de condensateurs (C'1, C'2) et de moyens (D'1, D'2, D'3) pour isoler ou relier les condensateurs entre eux, de sorte à produire un potentiel de sortie (Vg) par transfert de charges entre les étages,
ledit circuit étant piloté par au moins deux potentiels de commande (V1, V2), lesdits condensateurs recevant un des potentiels de commande sur un premier pôle, les deux potentiels de commande oscillant entre une première et une deuxième valeurs (Vref, Vss) de sorte qu'ils commandent, d'une part, une phase de charge des condensateurs (C'1, C'2) lorsqu'ils passent de la première valeur (Vref) à la deuxième valeur (Vss) et, d'autre part, une phase de décharge des condensateurs lorsqu'ils passent de la deuxième valeur (Vss) à la première valeur (Vref),
**caractérisé en ce que** le circuit comprend un circuit de commande (CP, G2, G3, G4, G5) auto - oscillant, produisant sur ses sorties les potentiels de commande (V1,V2) et oscillant par le fait de recevoir rétroactivement lesdits potentiels de commande sur des entrées et étant agencé de sorte que ces potentiels de commande décroissent respectivement croissent dès qu'ils atteignent la première respectivement la deuxième valeur.

2. Circuit selon la revendication 1, **caractérisé en ce que** le circuit de commande comprend un comparateur (CP) pour comparer les potentiels de commande à un potentiel de référence (Vref) de sorte à modifier les valeurs des potentiels de commande en fonction du résultat de la comparaison.

3. Circuit selon la revendication 2, **caractérisé en ce que** le potentiel de référence (Vref) correspond à la première valeur des potentiels de commande.

4. Circuit selon l'une des revendications 2 à 3, **caractérisé en ce que** le circuit de commande comprend une bascule RS (G2, G3) en sortie du comparateur (CP), pour garantir un non - recouvrement des potentiels de commande (V1, V2).

5. Circuit selon la revendication 4, **caractérisé en ce que** le comparateur (CP) reçoit les potentiels de commande (V1, V2) sur des entrées inverseuses et **en ce que** la bascule est de type NON_ET.

6. Circuit selon l'une des revendications 4 ou 5, **caractérisé en ce que** les potentiels de commande sont produits par des circuits tampons pilotés par des sorties de la bascule.

7. Circuit selon l'une des revendications 2 ou 3, **caractérisé en ce que** les potentiels de commande sont produits par des circuits tampons pilotés par des sorties du comparateur.

8. Circuit selon l'une des revendications 6 ou 7, **caractérisé en ce que** les circuits tampons sont des inverseurs.

## Patentansprüche

1. Potential- bzw. Spannungsgeneratorschaltung vom Ladungspumpentyp, mit zwei Stufen, welche von Kondensatoren (C'1, C'2) sowie von Mitteln (D'1, D'2, D'3) zur Trennung der Kondensatoren voneinander und Verbindung miteinander gebildet werden, zur Erzeugung eines Ausgangspotentials (Vg) durch Ladungsüberführung zwischen den Stufen,
wobei die genannte Schaltung von wenigstens zwei Steuerpotentialen (V1,V2) getrieben wird, die genannenten Kondensatoren eines der Steuerpotentiale an einem ersten Pol zugeführt erhalten, und die beiden Steuerpotentiale zwischen einem ersten und einem zweiten Wert (Vref, Vss) oszillieren, derart daß sie einerseits beim Übergang von dem ersten Wert (Vref) in den zweiten Wert (Vss) eine Aufladungsphase der Kondensatoren (C'1, C'2) und andererseits beim Übergang von dem zweiten Wert (Vss) in den ersten Wert (Vref) eine Entladungsphase der Kondensatoren steuern,
**dadurch gekennzeichnet, daß** die Schaltung eine selbst- bzw.freischwingende Steuerschaltung (CP, G2, G3, G4, G5) aufweist, welche an ihren Ausgängen die Steuerpotentiale (V1, V2) erzeugt und die oszilliert, weil sie durch Rückführung diegenannten Steuersignale an Eingängen in solcher Zuordnung zugeführt erhält, daß diese Steuersignale abnehmen bzw. zunehmen, sobald sie den ersten bzw. den zweiten Wert annehmen.

2. Schaltung nach Anspruch 1, **dadurch gekennzeichnet, daß** die Steuerschaltung einen Komparator (CP) umfaßt, der die Steuerpotentiale mit einem Bezugspotential (Vref) vergleicht, um die Werte der Steuerpotentiale in Abhängigkeit vom Ergebnis des Vergleichs zu modifizieren.

3. Schaltung nach Anspruch 2, **dadurch gekennzeichnet, daß** das Bezugssignal (Vref) dem ersten Wert der Steuerpotentiale entspricht.

4. Schaltung nach einem der Ansprüche 2 bis 3, **dadurch gekennzeichnet, daß** die Steuerschaltung eine RS-Kippschaltung (G2, G3) im Ausgang des Komparators umfaßt, um zu gewährleisten, daß die Steuerpotentiale (V1,V2) sich nicht überlappen.

5. Schaltung nach Anspruch 4, **dadurch gekennzeichnet, daß** dem Komparator die Steuerpotentiale (V1, V2) an invertierenden Eingängen zugeführt werden und daß die Kippstufe vom NAND-Typ ist.

6. Schaltung nach einem der Ansprüche 4 oder 5, **dadurch gekennzeichnet, daß** die Steuerpotentiale durch von Ausgangsgrößen der Kippschaltung getriebene Pufferschaltungen erzeugt werden.

7. Schaltung nach einem der Ansprüche 2 oder 3, **dadurch gekennzeichnet, daß** die Steuerpotentiale durch von Ausgangsgrößen des Komparators getriebene Pufferschaltungen erzeugt werden.

8. Schaltung nach einem der Ansprüche 6 oder 7, **dadurch gekennzeichnet, daß** die Pufferschaltungen Invertierschaltungen sind.

## Claims

1. A potential generation circuit of charge pump type, this circuit including at least two stages formed of capacitors (C'1, C'2) and means (D'1, D'2, D'3) for isolating or interconnecting the capacitors, to generate an output potential (Vg) by charge transfer between the stages,
the circuit being driven by at least two control potentials (V1, V2), the capacitors receiving one of the control potentials on a first pole, the two control potentials oscillating between a first and a second value (Vref, Vss) so that they control, on the one hand, a charge phase of the capacitors (C'1, C'2) when they switch from the first value (Vref) to the second value (Vss) and, on the other hand, a discharge phase of the capacitors when they switch from the second value (Vss) to the first value (Vref),
**characterized in that** the circuit includes a self-oscillating control circuit (CP, G2, G3, G4, G5) generating on its outputs the control potentials (V1, V2) and oscillating by feedback receiving on its inputs said control potentials and being arranged so that these control potentials decrease, respectively increase, as soon as they reach the first or, respectively the second value.

2. The circuit of claim 1, **characterized in that** the control circuit includes a comparator (CP) for comparing the control potentials with a reference potential (Vref) to modify the values of the control potentials according to the result of the comparison.

3. The circuit of claim 2, **characterized in that** the reference potential (Vref) corresponds to the first value of the control potentials.

4. The circuit of one of claims 2 or 3,
**characterized in that** the control circuit includes an RS flip-flop (G2, G3) at the output of the comparator (CP), to guarantee that the control potentials (V1, V2) do not overlap.

5. The circuit of claim 4, **characterized in that** the comparator (CP) receives the control potentials (V1, V2) on inverting inputs and the flip-flop is of NAND type.

6. The circuit of one of claims 4 or 5, **characterized in that** the control potentials are generated by buffer circuits driven by outputs of the flip-flop.

7. The circuit of one of claims 2 or 3, **characterized in that** the control potentials are generated by buffer circuits driven by outputs of the comparator.

8. The circuit of one of claims 6 or 7, **characterized in that** the buffer circuits are inverters.
